(19) **Europäisches Patentamt**
**European Patent Office**
**Office européen des brevets**

(11) **EP 4 528 305 B1**

(12) **EUROPEAN PATENT SPECIFICATION**

(45) Date of publication and mention
of the grant of the patent:
**04.02.2026 Bulletin 2026/06**

(51) International Patent Classification (IPC):
*G01R 33/56* (2006.01)   *G06T 7/00* (2017.01)
*G01R 33/50* (2006.01)

(21) Application number: **23198152.3**

(52) Cooperative Patent Classification (CPC):
**G01R 33/5608; G01R 33/50; G06T 7/0012**

(22) Date of filing: **19.09.2023**

(54) **METHOD AND SYSTEM FOR CHARACTERIZING A SPATIAL PATTERN FOR A MICROSTRUCTURAL PROPERTY OF A BIOLOGICAL TISSUE**

VERFAHREN UND SYSTEM ZUR CHARAKTERISIERUNG EINES RÄUMLICHEN MUSTERS FÜR EINE MIKROSTRUKTURELLE EIGENSCHAFT EINES BIOLOGISCHEN GEWEBES

PROCÉDÉ ET SYSTÈME DE CARACTÉRISATION D'UN MOTIF SPATIAL POUR UNE PROPRIÉTÉ MICROSTRUCTURELLE D'UN TISSU BIOLOGIQUE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(43) Date of publication of application:
**26.03.2025 Bulletin 2025/13**

(73) Proprietors:
• **Siemens Healthineers AG**
**91301 Forchheim (DE)**
• **Centre Hospitalier Universitaire Vaudois**
**1011 Lausanne (CH)**

(72) Inventors:
• **Sommer, Stefan**
**8048 Zürich (CH)**
• **Kober, Tobias**
**1007 Lausanne (CH)**
• **Ravano, Veronica**
**1009 Pully (CH)**

(74) Representative: **Fischer, Michael**
**Siemens AG**
**Postfach 22 16 34**
**80506 München (DE)**

(56) References cited:
**US-A1- 2017 309 025      US-A1- 2017 345 149**
**US-A1- 2019 370 965      US-A1- 2020 015 734**

**Description**

The present disclosure is directed, in general, to imaging techniques for imaging biological objects, like tissues, using for instance Magnetic Resonance Imaging (MRI). More specifically, the present invention is directed to methods and systems for characterizing microstructural properties of biological tissue from a property map, e.g., from a spatial map of quantitative MRI (qMRI) parameters.

In most radiologically-diagnosed diseases (e.g., tumor, multiple sclerosis, Alzheimer's disease), radiologists identify an anatomical anomaly and monitor its evolution over time to establish the patient's diagnosis, prognosis and/or treatment planning. For instance, in multiple sclerosis, demyelinating lesions are typically detected in the brain using conventional MRI sequences. The progression of the disease is then evaluated by considering, among others, the evolution of brain lesions over time in terms of number of lesions and volume change. The pathophysiological mechanisms that are at the source of the progression of an anomaly (e.g., the accumulation of macrophages at the lesion border in multiple sclerosis) are often theoretically understood, yet not quantifiable using conventional clinical imaging techniques. However, it would be clinically relevant to characterize microstructural properties of normal-appearing tissue as it could be predictive of future progression (e.g., lesion enlargement for multiple sclerosis, hippocampus atrophy in Alzheimer's disease).

In this context, property mapping techniques like qMRI have been shown to be of interest to quantify tissue microstructural change in response to pathology, and to bring valuable complementary information to standard radiological metrics [1, 2]. In fact, property mapping like qMRI techniques allow to study microstructural tissue composition, both in abnormal and normal-appearing tissue. For instance, previous work has shown the relevance of estimating microstructural properties of normal-appearing tissue in multiple sclerosis [3]. In particular, a gradient of increasing alterations was found in periventricular normal-appearing tissue and showed to correlate with disability [4]. Other studies focused on the estimation of normal-appearing tissue surrounding multiple sclerosis lesions (so-called perilesional tissue) [5,6]. These findings suggest that estimating the relation between tissue microstructural properties and their location in space is of relevance to characterize a disease. However, to this date, solutions that are able to efficiently and precisely characterize such relation are still missing.

Indeed, existing solutions aim at characterizing microstructural alterations in normal-appearing tissue surrounding an area of interest by implementing a "ring-based approach". For instance, Vaneckova et al. [4] proposed to compute an Euclidean distance map, where each voxel of a brain image is associated with an intensity representing the distance to the border of the brain ventricles. Periventricular bands were then extracted by applying distance thresholds and discretizing the distance map. And finally, average qMRI values were estimated in each periventricular band and a gradient was observed by comparing values between different bands. Similar solutions were proposed in the papers of Shi et al. [5] and Wittayer et al. [6]. Document US 2017/0309025 A1 proposes to assess peritumoral heterogeneity by evaluating perfusion temporal dynamics of two ROIs and determining a separability between summarized perfusion measurements. Document US 2017/0345149 A1 proposes to use a tissue model receiving as input quantitative MRI data for estimating non-aqueous tissue volume of a portion of a subject.

One problem of the proposed solutions is a lack of sensitivity that reduces the information that can be extracted from the obtained results. Another disadvantage of existing techniques is that the information on spatial distribution of the tissue properties is not well condensed in an easily usable, ideally a scalar, value. This can be crucial for clinical adoption of such a metric.

An objective of the present invention is to propose a method and a system capable of precisely and efficiently characterizing the relation between a tissue microstructural property and its location in space with respect to a center of interest, notably in order to provide results based on quantitative metrics, e.g. qMRI metrics, that enable comparison between patients independently from an examination site or MRI apparatuses used for acquiring images of the patients.

Said objective is achieved according to the present invention by a method and a system for characterizing a tissue microstructural property in function of its location with respect to a center of interest according to the object of the independent claims. Dependent claims present further advantages of the invention.

The present invention concerns a computer-implemented method for characterizing a spatial distribution of a tissue microstructural property from quantitative imaging data, like qMRI data, the method comprising:

- receiving or acquiring, for a biological object and via a first interface, a property map, e.g. a qMRI map, for a tissue of said biological object, e.g. a brain, wherein said property map comprises voxels whose intensity represents a measured value V, notably a measurable quantitative value, of said microstructural property for said tissue, said microstructural property being for instance defined as a measurable quantitative parameter. In particular, said property map is a quantitative T1 or a quantitative T2 map of a brain, wherein, in this case, the measured or mapped brain tissue quantitative parameter or property is then the T1 or T2 relaxation time measured for instance in milliseconds. Said property map might be derived from another property map, for instance it can be a deviation map showing differences of measured quantitative values with respect to normative values (e.g., a z-scope map). Said property map might also be a combination of a T1 and T2 map, or a map of an electrical parameter/property of said tissue (e.g. tissue conductivity), or a map of magnetization transfer characteristics of a tissue (e.g. magnetization transfer ratio (MTR), fractional pool-size, exchange rates measured for a brain), or any other voxel-wise quantifiable property related to a tissue. Preferentially, the property map is acquired by qMRI. Optionally, it is acquired by qMRI combined with one or several other imaging techniques (e.g. computed tomography (CT) or ultrasound imaging technique) capable of quantifying a tissue microstructural property. Said property map might also be a CT image of said biological object configured for providing a map of said tissue microstructural property or parameter. In particular, said property map might be obtained by combining quantitative measurements of different tissue microstructural properties, i.e. by combining different quantitative parameters measured for a same voxel of the tissue. In particular, said property map might be a 2-dimension (2D) or 3-dimension (3D) map. Preferentially, said property map is a quantitative map;

- determining, for at least a set of said voxels, a distance $d$, e.g. an Euclidean distance , separating each voxel (i.e. its position) of said set from a center of interest (i.e. from the position of a center of interest, wherein said center of interest can be for instance a closest lesion boundary with respect to the considered voxel, or a center of a lesion, etc.) so that each voxel of said set be associated to a measured value $V$ and a determined distance $d$;

the method being characterized in that it comprises:

- fitting, for said set of voxels, a function $f$ to the measured values $V$ expressed in function of the determined distance $d$ in order to determine a set of fitting parameters $(\beta_1,...,\beta_N)$ with N a positive integer, $N \geq 1$, preferentially N=2, i.e. solving

$$V(d) \; = \; f(\beta_1,\ldots,\beta_N,d) \quad \text{Eq. 1}$$

wherein $V(d)$ is the measured value $V$ associated to a voxel located at the determined distance $d$ of said center of interest and $f$ is a function of the parameters $(\beta_1,...,\beta_N,d)$, the fitting parameters $(\beta_1,...,\beta_N)$ being therefore unknown parameters whose value, obtained after said fit, characterizes a spatial distribution of the measured values $V$;

- determining or extracting, from said fit, the values of each fitting parameter $(\beta_1,...,\beta_N)$;
- outputting, via a second interface, the value of at least one of said fitting parameters $(\beta_1,...,\beta_N)$.

The present invention also concerns a system for characterizing a spatial distribution of a tissue microstructural property from quantitative imaging data, said system comprising:

- a first interface for receiving or acquiring a property map, e.g., a qMRI map, for a tissue of a biological object, wherein said property map comprises voxels whose intensity represents a measured value $V$ of said microstructural property for said tissue;
- a memory for storing said property map;
- a control unit comprising a processor, the control unit being configured for

  Determining, for at least a set of said voxels, a distance $d$, e.g., a Euclidean distance, separating each voxel of said set from a center of interest so that each voxel of said set be associated to a measured value $V$ and a determined distance $d$;
  for said set of voxels, fitting a function $f(\beta_1,...,\beta_N,d)$ to the measured values $V$ along the determined distance $d$ according to $V(d) = f(\beta_1,...,\beta_N,d)$, wherein $V(d)$ is the measured value $V$ associated to a voxel of said set located at the determined distance $d$ of said center of interest, and $(\beta_1,...,\beta_N)$ are fitting parameters; extracting, from said fit, the values of each fitting parameter $(\beta_1,...,\beta_N)$;

- a second interface, connected to the control unit, and configured for outputting the value of at least one of said fitting parameters $(\beta_1,...,\beta_N)$. Said second interface might be the same as the first interface, and may comprise for instance a display connected to the control unit and configured for displaying the values of the fitting parameters $(\beta_1,...,\beta_N)$.

The present invention further concerns an imaging apparatus, e.g., an MRI apparatus, comprising the previously described system, wherein said imaging apparatus is typically configured for acquiring said property map or deriving it from existing sequences (i.e., z-score maps).

Preferentially, said method comprises, and the control unit is configured for, comparing the value obtained for at least one of said fitting parameter, e.g. said outputted value, to a reference value. In particular, if a difference between said value, notably the outputted value, and the reference value is greater than a predefined threshold, then the method comprises automatically sending a warning signal. In other words, said comparison might be used for triggering an automatic sending of said warning signal.

Optionally, said method comprises, and the control unit is configured for, automatically classifying the tissue in a class of tissue in function of the value of at least one of said fitting parameters, e.g. in function of the outputted value.

Preferentially, if said microstructural property of the tissue is anisotropic, i.e. varies in the space in function of the location of the voxel, then the function **f** may further depend on different anisotropic directions within the tissue, and thus on the position of the voxel in addition to said distance **d**. For instance, Equation 1 could be expressed as

$$V(\vec{r}, d) = f(\beta_1, ..., \beta_N, \vec{r}, d) \qquad \text{Eq. 2}$$

wherein $\vec{r}$ represents the position (e.g. the coordinates) of the voxel within a frame of reference, **d** is the determined distance between the position of said voxel and said center of interest, i.e. the position of said center of interest within said frame of reference.

In particular, said set of voxels might be obtained by applying a mask to the property map in order to select, by means of said mask, voxels belonging to a specific region of said biological object and which form said set. Such a mask configured for defining or selecting a specific region within a biological object as well as the technique used for applying such a mask to a map are known in the art and therefore do not need to be further described here. Alternatively, said set of voxels might be obtained by clustering the voxels of the property map, using for instance k-means clustering techniques.

The foregoing has broadly outlined the features and technical advantages of the present disclosure so that those skilled in the art may better understand the detailed description that follows. Additional features and advantages of the disclosure will be described hereinafter that form the object of the claims. Those skilled in the art will appreciate that they may readily use the concept and the specific embodiment disclosed as a basis for modifying or designing other structures for carrying out the same purposes of the present disclosure. Those skilled in the art will also realize that such constructions do not depart from the scope of the disclosure as defined by the set of claims.

For a more complete understanding of the present disclosure, and the advantages thereof, reference is now made to the following descriptions taken in conjunction with the accompanying drawings, wherein like numbers designate like objects, and in which:

Figure 1 illustrates a flowchart of a method for characterizing a spatial distribution of a microstructural property of a tissue from qMRI data according to the invention;

Figure 2 illustrates a preferred embodiment of a system for characterizing a spatial distribution of a microstructural property of a tissue from qMRI data according to the invention;

Figure 3 schematically represents a lesion surrounded by normal-appearing tissue;

Figure 4 presents a graph of measured values **V** for T1 relaxation time in function of the distance **d** obtained for the lesion of Fig. 3 and fitted by a preferred function **f** according to the invention;

Figures 5 & 6 present experimental results when applying the method according to the invention;

Figure 7 presents a schematic comparison of the fitting results for a same type of tissue.

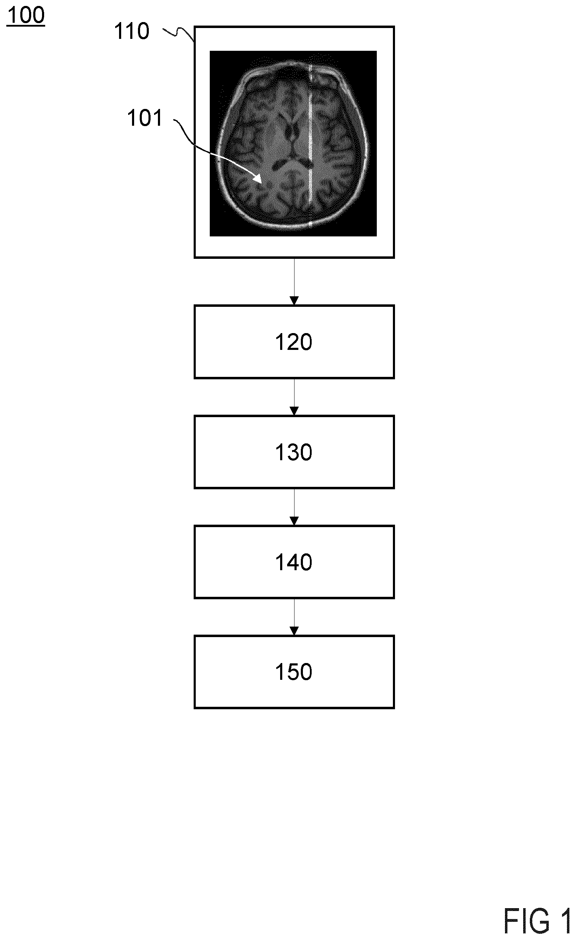

Figures 1 to 7, discussed below, and the various embodiments used to describe the principles of the present disclosure in this patent document are by way of illustration only and should not be construed in any way to limit the scope of the disclosure. Those skilled in the art will understand that the principles of the present disclosure may be implemented in any suitably arranged device. The numerous innovative teachings of the present application will be described with reference to exemplary non-limiting embodiments.

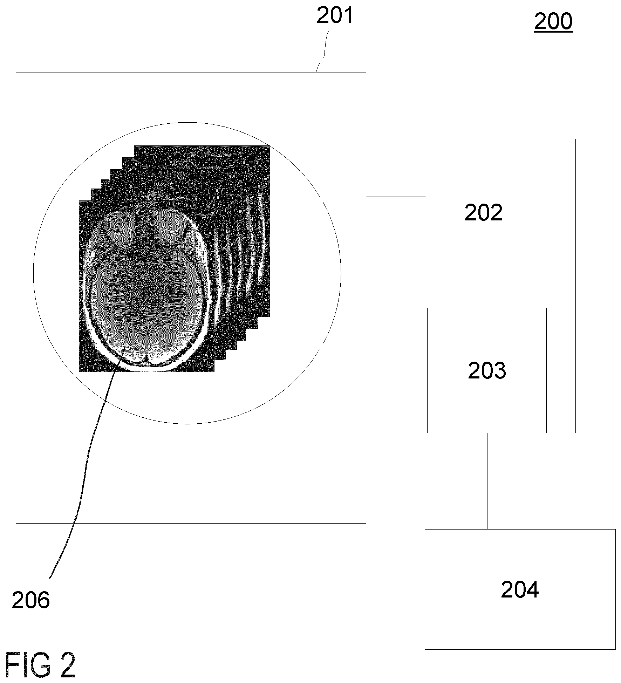

We will now describe in more details the method according to the invention through Figure 1 and 2, wherein Figure 1 describes the different steps of the method 100 carried out by a preferred embodiment of the system 200 according to the invention which is illustrated by Figure 2.

In Figure 2, a control unit 202 of the system 200 according to the invention is preferentially connected, for instance via a first interface, to a known in the art imaging apparatus, e.g. an MRI apparatus 201. While qMRI will be taken as concrete illustration of the present invention, other imaging apparatus might be connected to the system 200 according to the invention, as long as it can provide the system 200 with a property or quantitative map of a tissue microstructural property for a tissue of a biological object 206.

The MRI apparatus 201 typically comprises different coils and respective coil controllers configured for generating magnetic fields and RF pulses in order to acquire an MRI signal from the biological object 206, e.g. a brain, under investigation. Said MRI signal is transmitted by a receiver coil controller to the control unit 202. The latter might be configured for reconstructing qMRI maps of the biological object 206 from said MRI signal. In particular, the control unit 202 might be configured for controlling the MRI apparatus 201 so that the latter performs MR imaging enabling an acquisition of qMRI maps. Alternatively or additionally, the control unit 202 might be connected to a database or any other system for acquiring or receiving, e.g. via said first interface, a property map, e.g. a qMRI map, of the tissue microstructural property of said biological object. Said control unit 202 comprises typically a memory 203 and is connected to a second interface, e.g. a display 204 for displaying images reconstructed from the received MRI signal. The system 200 according to the invention might also be part of the MRI apparatus 201.

According to the present invention, the system 200 is configured for carrying out the following steps:
At step 110, the system 200, e.g. its control unit 202, receives or acquires one or several property maps configured for mapping a microstructural property of a tissue of the biological object 206. Said property maps are for instance qMRI maps 101 obtained from MRI scans of a brain according to known in the art techniques configured for providing quantitative MRI data. Said property map might by any map derived from a qMRI map, like a z-score map.

According to the present invention, the property map is a biological object map made of voxels, wherein the intensity value of each voxel is a measure of a tissue parameter (or property) obtained, for said biological object 206, via a quantitative imaging technique, preferentially a qMRI technique. In particular, a qMRI map according to the invention is for instance:

- T1 map, measuring T1 relaxation time;
- T2 map, measuring T2 relaxation time;
- T2* map, measuring T2* relaxation time;
- T1$\rho$ map, measuring T1$\rho$ relaxation time;
- MT (magnetization transfer), measuring tissue myelination;
- any diffusivity map, such as tissue fractional anisotropy;
- myelin water imaging, measuring tissue myelination;
- quantitative conductivity map, measuring tissue electrical conductivity;
- quantitative susceptibility map, measuring tissue magnetic susceptibility;
- quantitative elastography map, measuring tissue mechanical stiffness.

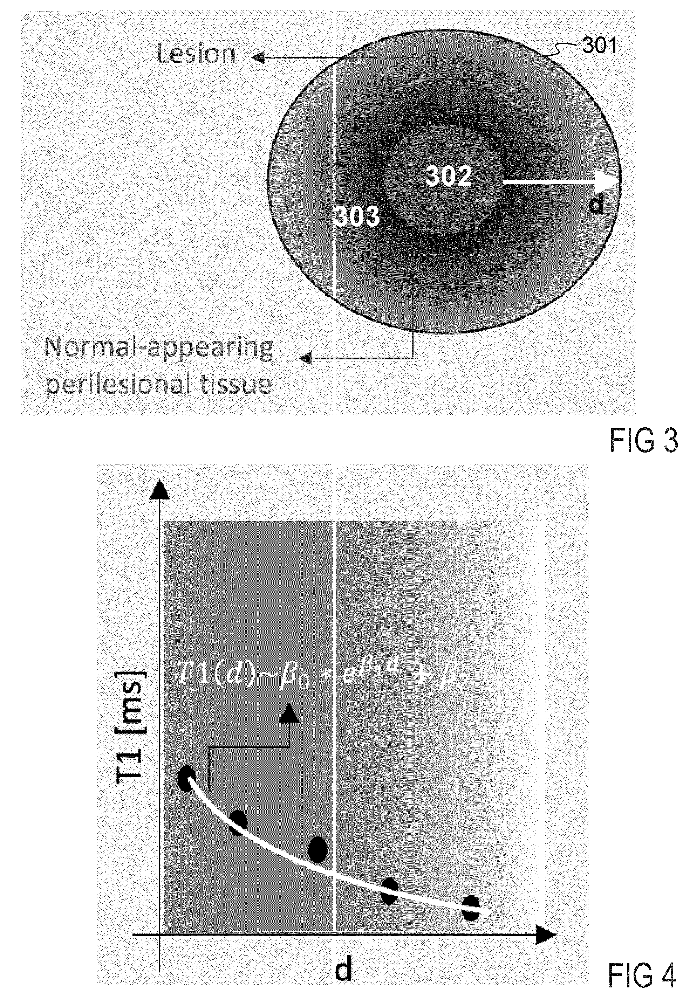

Figure 3 schematically represents an acquired property map 301 for a tissue of a biological object. As shown in Fig. 3, the acquired property map 301 may cover a region of the biological object 206 that comprises a lesion 302 surrounded by normal-appearing perilesional tissue 303. The present invention enables notably to characterize a microstructural property of said perilesional tissue 303.

At step 120, the system 200, e.g., its control unit 202, determines or measures, for each voxel of a set of voxels within said property map, a distance d, which is preferentially a Euclidean distance, separating the concerned voxel of said set from a center of interest. Said set of voxels may comprise all voxels of the property map, or might be selected according to any known techniques, for instance by applying a mask to the acquired property map so as to select only a single type of tissue within the biological object, or only a part of the latter. At the end of step 120, each voxel of said set is thus associated to a distance $d$ determined or measured for said voxel (i.e. if the set comprises for instance N voxels $v_1,...,v_N$, then to each voxel $v_i$ of the set, with $i \in \{1,..,N\}$, is associated a distance $d_i$). Preferentially, said distance $d$ is then stored, for each voxel of the set, in the memory 203 of the system 200 according to the invention. In the illustration of the invention presented in Figure 3, the center of interest is preferentially a boundary of the lesion (i.e. the boundary between the lesion and the normal-appearing perilesional tissue), said distance $d$ being the Euclidean distance between said boundary and the considered voxel. The center of interest can be the center of the lesion itself, or a border of the lesion (e.g., the closest border of the lesion) or a predefined spatial area in the biological object (e.g., a whole brain area such as the hippocampus or any other spatially defined region, e.g., periventricular region), or a specific anatomical landmark.

At step 130, the system 200, notably its control unit 202, is configured for fitting, for said set of voxels, a function $f$ to the measured values $V$ expressed in function of the determined distance $d$. This is better understood with the illustrations of Fig. 3 and 4. Let's suppose that the property map 301 shown in Fig. 3 is a T1 map of a brain region comprising the lesion 302. The (intensity) value $V$ of each voxel of the map is thus a T1 relaxation time that has been measured at a specific position within the biological object. The set of voxels is then for instance the voxels comprised in the normal-appearing perilesional region (see the perilesional tissue 303 in Fig. 3) surrounding the lesion 301. For each voxel of the set, the Euclidean distance $d$ between the voxel and the border of the lesion has been measured by the control unit 202 from the position of the voxel and the position of the border. Figure 4 shows then a graph representing the measured value $V$, i.e. the T1 relaxation time expressed in milliseconds in the present case, in function of the distance $d$ expressed for instance in millimeter. This gives rise to a cloud of points that is then fitted by the function $f$ according to $V(d) = f(\beta_1,...,\beta_N,d)$ wherein fitting parameters $(\beta_1,...,\beta_N)$ are the unknown in the equation, and have thus to be determined. In the example of Fig. 4, $f = \beta_0 \cdot e^{-\beta_1 d} + \beta_2$, giving rise to

$$V(d) = T1(d) = \beta_0 \cdot e^{-\beta_1 d} + \beta_2 \qquad \text{Eq. 3}$$

wherein $\beta_0$, $\beta_1$, and $\beta_2$ are the fitting parameters that need to be determined by the control unit 202. The mathematical model used for fitting $V(d)$ can be based on any type of function (like the exponential function presented in association with Fig. 4), mathematical or geometrical transform or operation.

At step 140, the system 200, preferably its control unit 202, is configured for determining, from said fit, the values of each fitting parameter $(\beta_1,...,\beta_N)$. For instance, according to the example provided in Fig. 4, the control unit 202 will be configured for determining the value of the fitting parameters $\beta_0$, $\beta_1$, and $\beta_2$.

At step 150, the system 200, preferably its control unit 202, is configured for outputting the value of at least one of said fitting parameters. For instance, the control unit 202 may output the value of the fitting para-

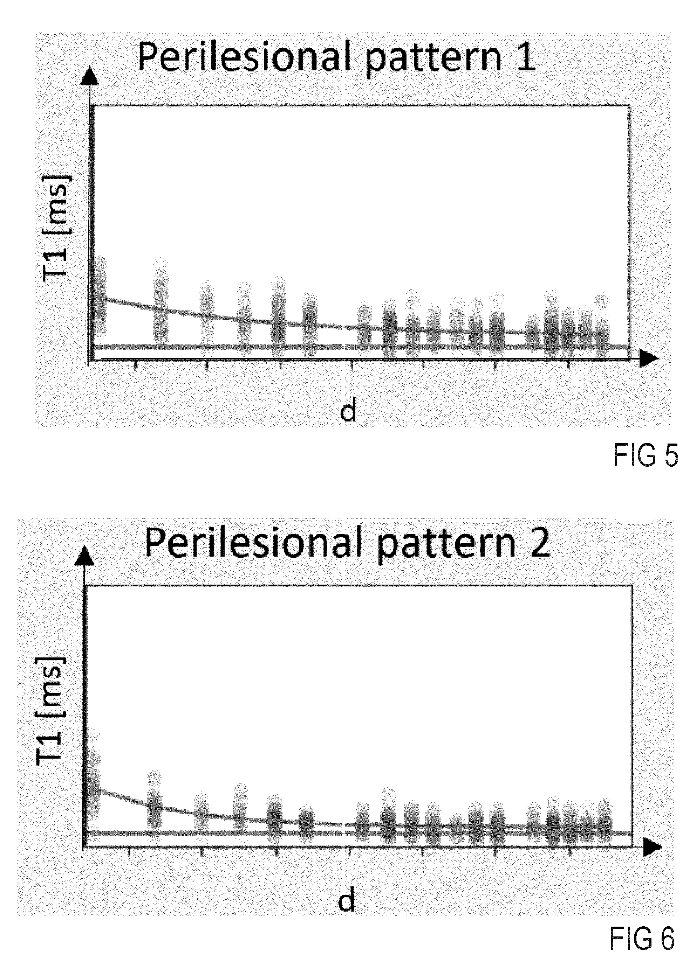

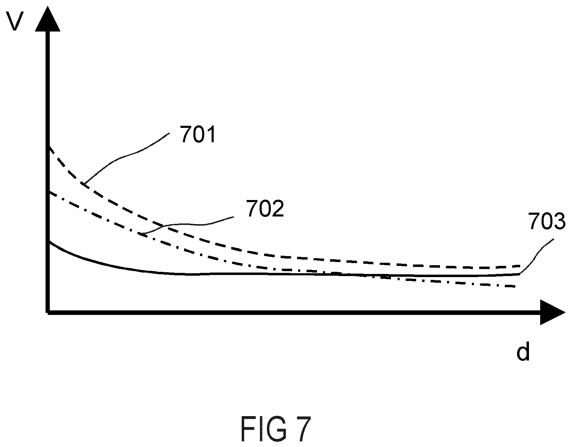

meter $\beta_1$ and use the latter for a comparison with a reference value or for performing group-wise comparisons, for instance for identifying clusters of fitting parameters or cluster of fits (i.e., of fitting curves) that are alike (e.g., the closest to a mean), using for instance a k-means clustering method. Indeed, as shown in Fig. 5 and 6, measured values of the relaxation time T1 in function of the distance $d$ might differ when considering a first lesion (Figure 5) or a second lesion (Figure 6). Therefore, each lesion will present a different perilesional pattern (namely a perilesional pattern 1 for the first lesion and a perilesional pattern 2 for the second lesion, as illustrated in the presented graphs) that can be characterized by the fitting parameters whose values (which are metrics) enable to compare the obtained pattern with a reference pattern (i.e. with reference values for said fitting parameters). Such comparison is better illustrated in Fig. 7, wherein, for a same type of tissue, different fitting curves 701, 702, 703 of the value $V$ in function of the distance $d$ have been obtained each for a different biological object. The fitting parameters enable thus to spatially characterize the microstructural property of a tissue under examination. Notably, deviations of the value of a fitting parameter with respect to a reference value (e.g. obtained from a cohort of healthy people) might be used as additional tool for clinical analysis of tissue. Additionally, the present invention further proposes to use different fits (e.g. different fitting mathematical formulas for the function $f$) for reflecting different microstructural mechanisms, such as different lesion types in multiple sclerosis. In such a case, the present invention may enable to distinguish, for a same type of tissue, multiple classes of non-healthy tissue.

Finally, at step 150, the system 200, notably its control unit 202, is configured for displaying, via the display 204, said at least one fitting parameter, for instance in association with a reference value.

An advantage of the present invention is that it is based on property maps. It relies thus on absolute physical parameters of the tissue, resulting in better comparability between longitudinal scans of the same patients, between multi-site acquisitions or between different cohorts of subjects (e.g., healthy vs. pathological patients) in comparison to conventional "weighted" imaging. In particular, it can be used for providing fitting parameter values independent from hardware and other spurious effects, enabling notably the creation of "normative values" for the fitting parameters which might be used for defining a range of normal values seen in "normal" tissue and that will thus characterize a "normal" spatial distribution of a microstructural property under analysis when considering a tissue of interest. A fitting parameter value obtained then for an individual patient can be checked against such normative values in order to determine if the spatial distribution of the microstructural property obtained for said patient is within the known range of normative values or not. This may for instance help to better characterize a disease and improve diagnosis, providing for instance support to a radiologist or other medical doctor for a clinical decision. In particular, the extracted or outputted fitting parameter(s) might be automatically classified in a class of tissue by the control unit 202, wherein one or several classes of tissue (typically, several classes for a same type of tissue) are for instance predefined in the memory 203 of the system 200 in function of such range of normal values for the fitting parameter(s).

Finally, the previously described invention presents the following advantages with respect to prior art techniques:

- It proposes a direct estimation of a spatial pattern measured for a microstructural property of a tissue;
- It has an increased sensitivity with respect to prior techniques, wherein spatial patterns were estimated from an independent evaluation of different subregions. Indeed, since all voxels of the set are considered simultaneously to model the spatial pattern or distribution of the microstructural property, all information is persevered, achieving a higher sensitivity to the characterization of such pattern. This might allow, e.g., to distinguish more complex pathologies from each other;
- It enables to determine spatial patterns which might be associated to specific (sub-) pathologies, lesion types or alike. Indeed, a spatial pattern (i.e. a fitting parameter) obtained for a biological object under analysis that is different from a normal pattern can then be categorized within a category of a set of categories, wherein each category defines a biologically different spatial pattern. For instance, a lesion can be associated to a category of lesions within a set of lesion categories that each represents a biologically different lesion pathology. The proposed method aggregates complex information contained in the property map and gives it a biological/medical meaning, facilitating the diagnostic assessment based on the fitting parameters.

To summarize, the present invention proposes to evaluate, within a tissue, a spatial distribution or pattern of a microstructural property of said tissue, wherein a mathematical model, i.e. said fitting function, is used for characterizing said spatial pattern from quantitative values acquired for said microstructural property, by associating each voxel of a property map acquired for said microstructural property with a continuous distance metric.

List of abbreviations

MR      magnetic resonance
MRI     magnetic resonance imaging
qMRI    quantitative magnetic resonance imaging
CT      computed tomography

List of citations:

[1] Li, Xiaojuan, and Sharmila Majumdar. "Quantitative MRI of articular cartilage and its clinical applications." Journal of Magnetic Resonance Imaging 38.5 (2013): 991-1008.

[2] Granziera, Cristina, et al. "Quantitative magnetic resonance imaging towards clinical application in multiple sclerosis." Brain 144.5 (2021): 1296-1311.

[3] Vrenken, Hugo, et al., "Whole-Brain T1 Mapping in Multiple Sclerosis: Global Changes of Normal-appearing Gray and White Matter" Radiology (2006).

[4] Vaneckova, Manuela et al., "Periventricular gradient of T1 tissue alterations in multiple sclerosis" Neuroimage:Clinical (2022).

[5] Shi, Zhuowei, et al., "Microstructural alterations in different types of lesions and their perilesional white matter in relapsing-remitting multiple sclerosis based on diffusion kurtosis imaging", Multiple Sclerosis and Related Disorders (2023).

[6] Wittayer, Matthias, et al., "Exploring (peri-) lesional and structural connectivity tissue damage through T1/T2-weighted ratio in iron rim multiple sclerosis lesions", Magnetic Resonance Imaging (2023).

**Claims**

1. A computer-implemented method (100) for characterizing a spatial distribution of a tissue microstructural property from quantitative imaging data, the method comprising

   - acquiring (110), for a biological object (206) and via a first interface, a property map for a tissue of said biological object (206), wherein said property map comprises voxels whose intensity represents a measured value $V$ of said microstructural property for said tissue;
   - determining (120), for at least a set of said voxels, a distance $d$ separating each voxel of said set from a center of interest so that each voxel of said set be associated to a measured value $V$ and a determined distance $d$;

   the method **characterized by**:

   - fitting (130), for said set of voxels, a function $f$ to the measured values $V$ expressed in function of the determined distance $d$ according to $V(d) = f(\beta_1,...,\beta_N,d)$ in order to determine a set of fitting parameters $(\beta_1,...,\beta_N)$;
   - determining (140), from said fit, the values of each fitting parameter $(\beta_1,...,\beta_N)$;
   - outputting (150) the value of at least one of said fitting parameters.

2. The computer-implemented method (100) of claim 1, comprising comparing the outputted value to a reference value.

3. The computer implemented method (100) of claim 2, comprising automatically sending a warning signal if a difference between said outputted value and the reference value is greater than a predefined threshold.

4. The computer-implemented method (100) according to one of the claims 1 to 3, comprising automatically classifying the tissue in a class of tissue in function of the value of at least one of said fitting parameters.

5. The computer-implemented method (100) according to one of the claims 1 to 4, wherein the function $f$ further depends on a position $\vec{r}$ of the voxel within a frame of reference according to $V(\vec{r}, d) = f(\beta_1, ..., \beta_N, \vec{r}, d)$.

6. System (200) for characterizing a spatial distribution of a tissue microstructural property from quantitative imaging data, said system (200) comprising:

   - a first interface for receiving or acquiring a property map for a tissue of a biological object (206), wherein said property map comprises voxels whose intensity represents a measured value $V$ of said microstructural property;
   - a memory (203) for storing said property map;
   - a control unit (202) comprising a processor, the control unit (203) being configured for carrying out the steps of the method according to claim 1;
   - a second interface, connected to the control unit (202), for outputting the value of at least one of said fitting parameters.

7. System (200) according to claim 6, wherein the control unit (202) is further configured for comparing the outputted value to a reference value.

8. System (200) according to claim 7, wherein the control unit (202) is further configured for automatically sending a warning signal if a difference between said outputted value and the reference value is greater than a predefined threshold.

9. System (200) according to one of the claims 6-8, wherein the control unit (202) is further configured for automatically classifying the tissue in a class of tissue in function of the value of at least one of said fitting parameters.

10. System (200) according to one of the claims 6-9, wherein the function *f* further depends on a position $\vec{r}$ of the voxel within a frame of reference according to $V(\vec{r}, d) = f(\beta_1, ..., \beta_N, \vec{r}, d)$.

11. Imaging apparatus comprising the system according to one of the claims 6 to 10.

12. Imaging apparatus according to claim 11, wherein said imaging apparatus is a Magnetic Resonance Imaging apparatus.


**Patentansprüche**

1. Computerimplementiertes Verfahren (100) zum Charakterisieren einer räumlichen Verteilung einer Gewebemikrostruktureigenschaft aus quantitativen Bilddaten, wobei das Verfahren umfasst:

   - Erfassen (110), für ein biologisches Objekt (206) und über eine erste Schnittstelle, einer Eigenschaftskarte für ein Gewebe des biologischen Objekts (206), wobei die Eigenschaftskarte Voxel umfasst, deren Intensität einen Messwert *V* der Mikrostruktureigenschaft für das Gewebe darstellt;
   - Bestimmen (120), für zumindest eine Menge der Voxel, eines Abstands *d,* der jedes Voxel der Menge von einem Interessenzentrum trennt, so dass jedes Voxel der Menge einem Messwert *V* und einem bestimmten Abstand *d* zugeordnet ist;

   wobei das Verfahren **gekennzeichnet ist durch**:

   - Anpassen (130), für die Menge von Voxeln, einer Funktion *f* an die Messwerte *V,* ausgedrückt abhängig von dem bestimmten Abstand *d* gemäß $V(d) = f(\beta_1,...,\beta_N, d)$, um eine Menge von Anpassungsparametern $(\beta_1,...,\beta_N)$ zu bestimmen;
   - Bestimmen (140), aus der Anpassung, der Werte jedes Anpassungsparameters $(\beta_1,...,\beta_N)$;
   - Ausgeben (150) des Werts von zumindest einem der Anpassungsparameter.

2. Computerimplementiertes Verfahren (100) nach Anspruch 1, umfassend Vergleichen des ausgegebenen Werts mit einem Referenzwert.

3. Computerimplementiertes Verfahren (100) nach Anspruch 2, umfassend automatisches Senden eines Warnsignals, wenn eine Differenz zwischen dem ausgegebenen Wert und dem Referenzwert größer als ein vordefinierter Schwellenwert ist.

4. Computerimplementiertes Verfahren (100) nach einem der Ansprüche 1 bis 3, umfassend automatische Klassifizierung des Gewebes in eine Gewebeklasse abhängig von dem Wert von zumindest einem der Anpassungsparameter.

5. Computerimplementiertes Verfahren (100) nach einem der Ansprüche 1 bis 4, wobei die Funktion *f* ferner von einer Position $\vec{r}$ des Voxels innerhalb eines Referenzsystems abhängt gemäß $V(\vec{r}, d) = f(\beta_1, ..., \beta_N, \vec{r}, d)$.

6. System (200) zum Charakterisieren einer räumlichen Verteilung einer Gewebemikrostruktureigenschaft aus quantitativen Bilddaten, wobei das System (200) umfasst:

   - eine erste Schnittstelle zum Empfangen oder Erfassen einer Eigenschaftskarte für ein Gewebe eines biologischen Objekts (206), wobei die Eigenschaftskarte Voxel umfasst, deren Intensität einen Messwert *V* der Mikrostruktureigenschaft darstellt;
   - einen Speicher (203) zum Speichern der Eigenschaftskarte;
   - eine Steuereinheit (202), umfassend einen Prozessor, wobei die Steuereinheit (203) konfiguriert ist zum Durchführen der Schritte des Verfahrens nach Anspruch 1;
   - eine zweite Schnittstelle, verbunden mit der Steuereinheit (202), zum Ausgeben des Werts von zumindest einem der Anpassungsparameter.

7. System (200) nach Anspruch 6, wobei die Steuereinheit (202) ferner konfiguriert ist zum Vergleichen des ausgegebenen Werts mit einem Referenzwert.

8. System (200) nach Anspruch 7, wobei die Steuereinheit (202) ferner konfiguriert ist zum automatischen Senden eines Warnsignals, wenn eine Differenz zwischen dem ausgegebenen Wert und dem Referenzwert größer als ein vordefinierter Schwellenwert ist.

9. System (200) nach einem der Ansprüche 6-8, wobei die Steuereinheit (202) ferner konfiguriert ist zum automatischen Klassifizieren des Gewebes in eine Gewebeklasse abhängig von dem Wert von zumindest einem der Anpassungsparameter.

10. System (200) nach einem der Ansprüche 6-9, wobei die Funktion *f* ferner von einer Position $\vec{r}$ des Voxels innerhalb eines Referenzsystems abhängt gemäß $V(\vec{r}, d) = f(\beta_1, ..., \beta_N, \vec{r}, d)$.

**11.** Bildgebungsvorrichtung, umfassend das System nach einem der Ansprüche 6 bis 10.

**12.** Bildgebungsvorrichtung nach Anspruch 11, wobei die Bildgebungsvorrichtung eine Magnetresonanztomographie-Vorrichtung ist.

**Revendications**

**1.** Procédé mis en œuvre par ordinateur (100) de caractérisation d'une distribution spatiale d'une propriété microstructurale d'un tissu à partir de données d'imagerie quantitatives, le procédé comprenant

- l'acquisition (110), pour un objet biologique (206) et via une première interface, d'une carte de propriétés pour un tissu dudit objet biologique (206), dans lequel ladite carte de propriétés comprend des voxels dont l'intensité représente une valeur mesurée $V$ de ladite propriété microstructurale pour ledit tissu ;
- la détermination (120), pour au moins un ensemble desdits voxels, d'une distance $d$ séparant chaque voxel dudit ensemble d'un centre d'intérêt de sorte que chaque voxel dudit ensemble soit associé à une valeur mesurée $V$ et à une distance déterminée $d$ ;

le procédé étant **caractérisé par** :

- l'ajustement (130), pour ledit ensemble de voxels, d'une fonction $f$ aux valeurs mesurées $V$ exprimées en fonction de la distance déterminée $d$ selon $V(d) - f(\beta_1, ..., \beta_N, d)$ afin de déterminer un ensemble de paramètres d'ajustement $(\beta_1, ..., \beta_N)$ ;
- la détermination (140), à partir dudit ajustement, des valeurs de chaque paramètre d'ajustement $(\beta_1, ..., \beta_N)$ ;
- la sortie (150) de la valeur d'au moins un desdits paramètres d'ajustement.

**2.** Procédé mis en œuvre par ordinateur (100) selon la revendication 1, comprenant la comparaison de la valeur délivrée en sortie à une valeur de référence.

**3.** Procédé mis en œuvre par ordinateur (100) selon la revendication 2, comprenant l'envoi automatique d'un signal d'avertissement si une différence entre ladite valeur délivrée en sortie et la valeur de référence est supérieure à un seuil prédéfini.

**4.** Procédé mis en œuvre par ordinateur (100) selon l'une des revendications 1 à 3, comprenant le classement automatique du tissu dans une classe de tissus en fonction de la valeur d'au moins un desdits paramètres d'ajustement.

**5.** Procédé mis en œuvre par ordinateur (100) selon l'une des revendications 1 à 4, dans lequel la fonction $f$ dépend en outre d'une position $\vec{r}$ du voxel dans un repère selon $V(\vec{r}, d) = f(\beta_1, ..., \beta_N, \vec{r}, d)$.

**6.** Système (200) de caractérisation d'une distribution spatiale d'une propriété microstructurale d'un tissu à partir de données d'imagerie quantitatives, ledit système (200) comprenant :

- une première interface pour recevoir ou acquérir une carte de propriétés pour un tissu d'un objet biologique (206), dans lequel ladite carte de propriétés comprend des voxels dont l'intensité représente une valeur mesurée $V$ de ladite propriété microstructurale ;
- une mémoire (203) pour stocker ladite carte de propriétés ;
- une unité de commande (202) comprenant un processeur, l'unité de commande (203) étant configurée pour réaliser les étapes du procédé selon la revendication 1 ;
- une seconde interface, connectée à l'unité de commande (202), pour délivrer en sortie la valeur d'au moins un desdits paramètres d'ajustement.

**7.** Système (200) selon la revendication 6, dans lequel l'unité de commande (202) est en outre configurée pour comparer la valeur délivrée en sortie à une valeur de référence.

**8.** Système (200) selon la revendication 7, dans lequel l'unité de commande (202) est en outre configurée pour envoyer automatiquement un signal d'avertissement si une différence entre ladite valeur délivrée en sortie et la valeur de référence est supérieure à un seuil prédéfini.

**9.** Système (200) selon l'une des revendications 6 à 8, dans lequel l'unité de commande (202) est en outre configurée pour classer automatiquement le tissu dans une classe de tissus en fonction de la valeur d'au moins un desdits paramètres d'ajustement.

**10.** Système (200) selon l'une des revendications 6 à 9, dans lequel la fonction $f$ dépend en outre d'une position $\vec{r}$ du voxel dans un repère selon $V(\vec{r}, d) = f(\beta_1, ..., \beta_N, \vec{r}, d)$.

**11.** Appareil d'imagerie comprenant le système selon l'une des revendications 6 à 10.

**12.** Appareil d'imagerie selon la revendication 11, dans lequel ledit appareil d'imagerie est un appareil d'imagerie par Résonance Magnétique.

100

110

101

120

130

140

150

FIG 1

201

200

202

203

204

206

FIG 2

Lesion

Normal-appearing
perilesional tissue

301

302

303

d

FIG 3

$$T1(d) \sim \beta_0 * e^{\beta_1 d} + \beta_2$$

T1 [ms]

d

FIG 4

Perilesional pattern 1

FIG 5

Perilesional pattern 2

FIG 6

FIG 7

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20170309025 A1

- US 20170345149 A1

**Non-patent literature cited in the description**

- **LI, XIAOJUAN ; SHARMILA MAJUMDAR.** Quantitative MRI of articular cartilage and its clinical applications.. *Journal of Magnetic Resonance Imaging*, 2013, vol. 38.5, 991-1008
- **GRANZIERA, CRISTINA et al.** Quantitative magnetic resonance imaging towards clinical application in multiple sclerosis.. *Brain*, 2021, vol. 144.5, 1296-1311
- **VRENKEN, HUGO et al.** Whole-Brain T1 Mapping in Multiple Sclerosis: Global Changes of Normal-appearing Gray and White Matter. *Radiology*, 2006

- **VANECKOVA, MANUELA et al.** Periventricular gradient of T1 tissue alterations in multiple sclerosis. *Neuroimage:Clinical*, 2022
- **SHI, ZHUOWEI et al.** Microstructural alterations in different types of lesions and their perilesional white matter in relapsing-remitting multiple sclerosis based on diffusion kurtosis imaging. *Multiple Sclerosis and Related Disorders*, 2023
- **WITTAYER, MATTHIAS et al.** Exploring (peri-) lesional and structural connectivity tissue damage through T1/T2-weighted ratio in iron rim multiple sclerosis lesions. *Magnetic Resonance Imaging*, 2023